(19)

**Europäisches Patentamt**

**European Patent Office**

**Office européen des brevets**

(11) **EP 1 265 347 A2**

(12) **EUROPÄISCHE PATENTANMELDUNG**

(43) Veröffentlichungstag:
**11.12.2002 Patentblatt 2002/50**

(51) Int Cl.⁷: **H02M 7/538**

(21) Anmeldenummer: **02012191.9**

(22) Anmeldetag: **03.06.2002**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **08.06.2001 DE 10127868**

(71) Anmelder: **GRUNDFOS A/S**
**DK-8850 Bjerringbro (DK)**

(72) Erfinder: **Petersen, Niels Hogholt**
**8850 Bjerringbro (DK)**

(74) Vertreter: **Vollmann, Heiko, Dipl.-Ing. et al**
**Patentanwälte Wilcken & Vollmann,**
**Bei der Lohmühle 23**
**23554 Lübeck (DE)**

(54) **Bootstrap-Spannungsversorgung**

(57) Die Bootstrap-Spannungsversorgung ist für den Gatetreiber (2b) eines Leistungshalbleiterschaltelements (1b) auf der Highside (b) eines Frequenzumrichters vorgesehen. Der Ausgang des Treibers (2b) ist mit dem Steuereingang des Schaltelements (1b) verbunden, das die Highside (b) des entsprechenden Frequenzumrichterarms schaltet. Um den Bootkondensator (6) kleiner dimensionieren zu können, ist eine aktive Strombegrenzung (7) und eine Spannungsregelung (12) vorgesehen, die dafür sorgt, dass der Ladestrom nur bis zu vorbestimmten Werten ansteigt und auch eine vorbestimmte Ladespannung nicht überschritten wird.

Figur 3

EP 1 265 347 A2

**Beschreibung**

Die Erfindung betrifft eine Bootstrap-Spannungsversorgung gemäß den im Oberbegriff des Anspruchs 1 angegebenen Merkmalen.

Derartige Bootstrap-Spannungsversorgungen sind bekannt, es wird in diesem Zusammenhang beispielhaft auf DE 198 17 767 A1 verwiesen. Solche Schaltungen werden insbesondere auch in elektronischen Frequenzumrichtern eingesetzt, um die Steuerspannung für die Gatetreiber bereitzustellen. Es wird in diesem Zusammenhang auf den Stand der Technik nach US-PS 6,147,887 verwiesen.

Ein Frequenzumrichter zur Ansteuerung eines Motors weist üblicherweise sechs Leistungshalbleiterschaltelemente auf, die jeweils paarweise einer Motorwicklung zugeordnet sind und in an sich bekannter Weise angesteuert werden, um den Motor in der gewünschten Weise zu fahren.

Um die Leistungshalbleiterschaltelemente, beispielsweise Transistoren, anzusteuern, wird ein Schaltspannung von z. B. 15 Volt zwischen Basis und Emitter benötigt. Während dies auf der Lowside, wo der Emitter eines Transistors regelmäßig potentialfrei liegt, unproblematisch ist, ist auf der Highside der Emitter des Transistors mit dem Potential des Umrichterausgangs verbunden, das sich schaltbedingt ständig ändert. Hier kann eine Bootstrap-Spannungsversorgung eingesetzt werden, um auch eine entsprechende Änderung der Steuerspannung des Gatetreibers herbeizuführen. Eine solche Bootstrap-Spannungsversorgung besteht typischerweise aus einer Bootdiode, die mit ihrer Anode an einer im Wesentlichen konstanten Spannung $V_{cc}$ anliegt und kathodenseitig meist über einen Bootstrap-Widerstand mit einer Seite eines Bootstrap-Kondensators verbunden ist, der die Steuerspannung des Gatetreibers bildet.

Nachteilig bei einer solchen bekannten Bootstrap-Spannungsversorgung ist, dass der Bootstrap-Kondensator vergleichsweise groß dimensioniert sein muss, um hohe Ladeströme aufnehmen zu können. Andererseits muss die Spannungsversorgung entsprechend groß dimensioniert sein. Darüber hinaus ist eine Bootstrap-Spannungsversorgung bekannter Art bei hochdynamischen Systemen mit kurzen Pulsen nur sehr bedingt einsetzbar.

Vor diesem Hintergrund liegt der Erfindung die Aufgabe zugrunde, eine Bootstrap-Spannungsversorgung der eingangs beschriebenen Art zu verbessern.

Diese Aufgabe wird gemäß der Erfindung durch die in Anspruch 1 angegebenen Merkmale gelöst. Vorteilhafte Ausgestaltungen der Erfindung sind in den Unteransprüchen, der nachfolgenden Beschreibung sowie der Zeichnung angegeben.

Grundgedanke der vorliegenden Erfindung ist es, die Bootstrap-Spannungsversorgung mindestens mit einer aktiven Strombegrenzung, und mit einer Spannungsregelung auszustatten. Hierdurch können die Ladeströme des Kondensators begrenzt werden, so dass die Bauteile der Bootstrap-Spannungsversorgung insgesamt kleiner dimensioniert werden können, insbesondere jedoch der Kondensator, der sowohl von der Baugröße als auch von den Baukosten besonders ins Gewicht fällt.

Bevorzugt ist der aktive Strombegrenzer und/oder der Spannungsregler zwischen die Bootdiode und den Bootkondensator geschaltet, wobei für die Spannungsregelung die Schaltung zwischen Bootdiode und der umrichterausgangsseitigen Seite des Bootkondensators und für die Strombegrenzung zwischen Bootdiode und der anderen Seite des Kondensators angeordnet ist.

Vorteilhaft ist es, wenn der Strombegrenzer durch zwei zwischen Bootdiode und Bootkondensator mit ihrer Kollektor-Emitter-Strecke parallelgeschaltete Transistoren gebildet wird, bei denen die Basis des einen Transistors mit dem Kollektor des anderen Transistors und über einen Reihenwiderstand mit der Bootdiode und die Basis des anderen Transistors mit dem Emitter des einen Transistors und über einen Reihenwiderstand mit dem Bootkondensator verbunden ist. Eine solche Anordnung ist besonders günstig, da sie mit wenigen elektronischen Bauteilen kostengünstig zu realisieren ist.

Die Spannungsversorgung sollte dabei so ausgelegt werden, dass die Versorgungsspannung mindestens 3 Volt über der Schaltspannung des Schaltelementes liegt, damit stets sichergestellt ist, dass eine ausreichend hohe Steuerspannung am Treiber anliegt.

In Weiterbildung der Erfindung kann die Bootstrap-Spannungsversorgung mit einem Spannungsregler versehen sein, indem parallel zum Strombegrenzer und dem Bootkondensator eine Zenerdiode geschaltet wird. Dabei liegt die Anode der Zenerdiode am Umrichterausgang des Schaltelements an und die Kathode über einen Reihenwiderstand an der Kathode der Bootdiode und an der Basis des Transistors, der unmittelbar mit der Bootdiode verbunden ist an.

Der Bootkondensator ist üblicherweise als Tantalkondensator ausgelegt, der bekanntermaßen keine großen Ladeströme verträgt und auch hohe Baukosten bedingt. Es ist deshalb ein stetes Bemühen, die Kapazität des notwendigerweise vorzusehenden Tantalkondensators so gering wie möglich zu halten. Dies kann gemäß der Erfindung dadurch erreicht werden, dass parallel zum Spannungsregler ein weiterer Kondensator geschaltet ist, wobei dann die Versorgungsspannung mindestens doppelt so hoch wie die Schaltspannung sein sollte. Dieser weitere Kondensator, der kein Tantalkondensator zu sein braucht, kann auf höherem Spannungsniveau Energie speichern und ermöglicht somit eine kleinere Dimensionierung des eigentlichen Bootkondensators.

Beim Parallelschalten eines weiteren Kondensators kann der Spannungsregler in einfacher Weise durch einen Transistor in Verbindung mit einer Zenerdiode und einem Widerstand gebildet sein, wobei die Kollektor-Emitter-Strecke des Transistors am Bootkondensator einerseits und kollektorseitig an der Kathode der Bootdiode andererseits angeschlossen ist. Die Zenerdiode liegt dabei am Umrichterausgang des Schaltelements anodenseitig und kathodenseitig an der Basis des Transistors an, die über einen Widerstand mit dem Kollektor verbunden ist.

Die Erfindung ist nachfolgend anhand von in der Zeichnung dargestellten Ausführungsbeispielen näher erläutert. Es zeigen:

Fig. 1 ein stark vereinfachtes Schaltbild einer Bootstrap-Spannungsversorgung mit zwei Gatetreibern und einem Schaltelementepaar eines Umrichters nach dem Stand der Technik,

Fig. 2 eine erste Ausführungsvariante gemäß der Erfindung mit einem Strombegrenzer in Darstellung nach Fig. 1,

Fig. 3 eine zweite Ausführungsvariante gemäß der Erfindung mit einem Spannungsregler und Strombegrenzer in Darstellung nach Fig. 1,

Fig. 4 eine dritte Ausführungsvariante gemäß der Erfindung mit einem Spannungsregler und zusätzlichem, parallelgeschaltetem Kondensator in Darstellung nach Fig. 1 und

Fig. 5 eine vierte Ausführungsvariante im Wesentlichen entsprechend der zweiten Ausführungsvariante nach Fig. 2, jedoch mit zusätzlich parallelgeschaltetem Kondensator ebenfalls in Darstellung nach Fig. 1.

In den Figuren ist jeweils ein Paar von Leistungstransistoren 1 eines Strangs des Leistungsteils eines Frequenzumrichters zur Ansteuerung eines Elektromotors dargestellt. Mit Hilfe dieser Transistoren 1 wird aus dem im Zwischenkreis des Frequenzumrichters anstehenden Gleichspannungssignal ein Wechselspannungssignal gewünschter Frequenz und Amplitude erzeugt, das über den Ausgang U der Motorwicklung zugeführt ist. Dabei wird durch den auf der Lowside befindlichen Transistor 1a die untere Halbwelle und über den auf der Highside befindlichen Transistor 1a die ober Halbwelle des Wechselpumpsignals erzeugt.

Angesteuert werden die Leistungstransistoren 1 über Treiber 2 (Gatetreiber), die über einen Widerstand 3 mit der Basis des jeweiligen Transistors 1 verbunden sind. Um die Transistoren 1 schalten zu können, müssen die Gatetreiber 2 eine Steuerspannung auf die Transistoren 1 geben, die typischerweise +15 Volt beträgt. Soweit es den Gatetreiber 2a der Lowside angeht, kann eine solche Steuerspannung durch entsprechende Dimensionierung der konstanten Versorgungsspannung $V_{cc}$ gegenüber Erde (Ground) GND sichergestellt werden. Der Gatetreiber 2b der Highside liegt jedoch mit einer Seite am Emitter des Transistors 1b auf dieser Seite, d. h. am Schaltausgang U, dessen Spannung sich je nach Schaltstellung ständig ändert. Da der Transistor 1b auf der Highside zum Schalten eine Spannung benötigt, die stets 15 Volt höher als die Spannung U ist, muss eine entsprechende Spannungsversorgung des zugehörigen Gatetreibers 2b vorgesehen sein. Hierzu ist eine Bootstrap-Spannungsversorgung vorgesehen, die für eine solch erhöhte Steuerspannung gegenüber U sorgt. Sie besteht aus einer anodenseitig an der Versorgungsspannung $V_{cc}$ anliegenden Bootdiode 4, die kathodenseitig an einen Bootwiderstand 5 anschließt, der mit einem Bootkondensator 6 verbunden ist, dessen andere Seite mit dem Umrichterausgang des Transistors 1b der Highside, also U, verbunden ist. Der Bootkondensator 6 liegt parallel zum Gatetreiber 2b, so dass die am Kondensator 6 anliegende Spannung zugleich auch die Steuerspannung des Treibers 2b bildet.

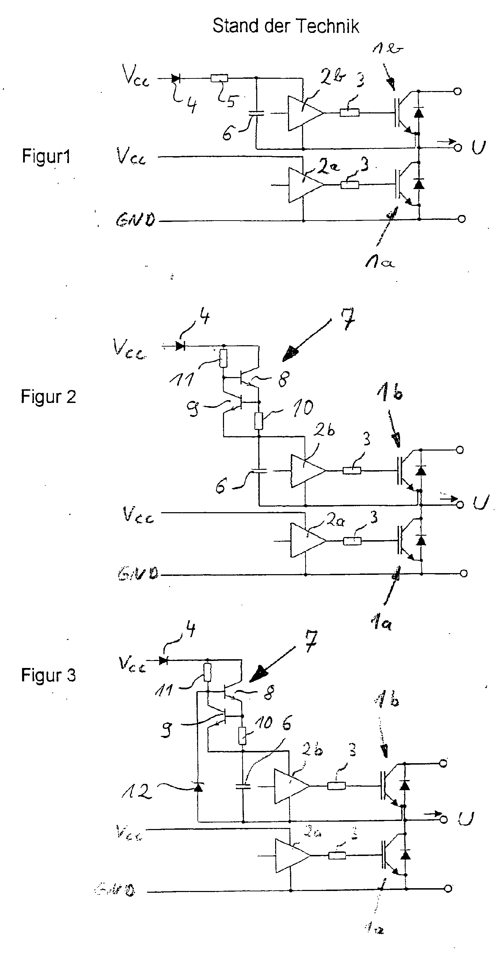

Dieser grundsätzliche Schaltungsaufbau, wie anhand der Fig. 1 beschrieben worden ist, zählt zum Stand der Technik und ist, wie sich aus den Figuren 2 bis 5 ergibt, auch Grundlage der erfindungsgemäßen Ausgestaltung. Soweit es die Gatetreiber 2, den Widerstand 3 und die angesteuerten Leistungstransistoren 1 angeht, stimmen die nachfolgend anhand der Figuren 2 bis 5 dargestellten Schaltungen identisch mit der vorbeschriebenen überein. Auch weisen sie sämtlichst eine Bootdiode 4 auf, die anodenseitig an der Versorgungsspannung $V_{cc}$ anliegt, sowie einen parallel zum Gatetreiber 2b liegenden Bootkondensator 6, an dem die Steuerspannung anliegt.

Bei der Ausführung gemäß Fig. 2 ist ein aktiver Strombegrenzer 7 vorgesehen, und zwar zwischen der Kathode der Bootdiode 4 und der nicht mit U verbundenen Seite des Bootkondensators 6. Der Strombegrenzer weist zwei Transistoren 8 und 9 sowie zwei Widerstände 10 und 11 auf. Der Transistor 8 liegt mit seinem Kollektor an der Kathodenseite der Bootdiode 4 an, sein Emitter ist über den Widerstand 10 mit der nicht an U anliegenden Seite des Bootkondensators 6 verbunden. Der zweite Transistor 9 liegt mit seinem Kollektor an der Basis des ersten Transistors 8 sowie an dem Widerstand 11 an, dessen andere Seite mit der Kathodenseite der Bootdiode 4 verbunden ist. Die Basis des Transistors 9 ist mit dem Emitter des Transistors 8 verbunden, der Emitter des Transistors 9 liegt an der Seite des Bootkondensators 6 an, die nicht mit U verbunden ist. Der Widerstand 10 ist so ausgelegt, dass der maximale Strom $I_{max}$ dem maximalen Ladestrom des Kondensators 6 angepaßt ist. Hier ist der maximale Strom wie folgt begrenzt:

$$I_{max} = 0,6 \text{ Volt} : R$$

Der Spannungsabfall am Widerstand 10 entspricht dem Basis-Emitter-Spannungsabfall des gewählten Transistors 9, der üblicherweise etwa 0,6 Volt beträgt. Der Widerstand 11 ist dem Zündstrom des Transistors 8 angepaßt. Damit ist der Ladestrom, der den Bootkondensator 6 lädt, begrenzt, so dass sowohl die Spannungsversorgung $V_{cc}$ als auch der Bootkondensator 6 im Vergleich zum Stand der Technik (Fig. 1) geringer dimensioniert sein kann.

Bei der Ausführungsvariante gemäß Fig. 3 ist neben dem Strombegrenzer 7 zusätzlich noch eine Zenerdiode 12 vorgesehen, welche eine Spannungsregelung bildet. Die Zenerdiode 12 liegt anodenseitig am Umrichterausgang U des Transistors 1b an, also insoweit parallel zum Bootkondensator 6. Kathodenseitig ist die Zenerdiode 12 mit der Seite des Widerstands 11 verbunden, die an der Basis des Transistors 8 anliegt. Die Zenerdiode ist so gewählt, dass die Spannung zwischen U und der Basis des Transistors 8 der Beziehung

$$\Delta U_{Zehnerdiode} = U_{Bootkondensator} + 2 \Delta \cdot U_{Transistor\ 8,9}$$

folgt. Wenn $U_{Bootkondensator}$ (die am Bootkondensator anliegende Spannung ) 15 Volt ist und der Basis-Emitterspannungsabfall am Transistor 8 und 9 jeweils 0,6 Volt beträgt, dann ergibt sich die Spannung $U_{zenerdiode}$ (an der Zenerdiode anliegende Spannung) zu 16,2 Volt. Hierdurch kann der Bootkondensator 6 hinsichtlich seiner Spannungsfestigkeit kleiner dimensioniert werden.

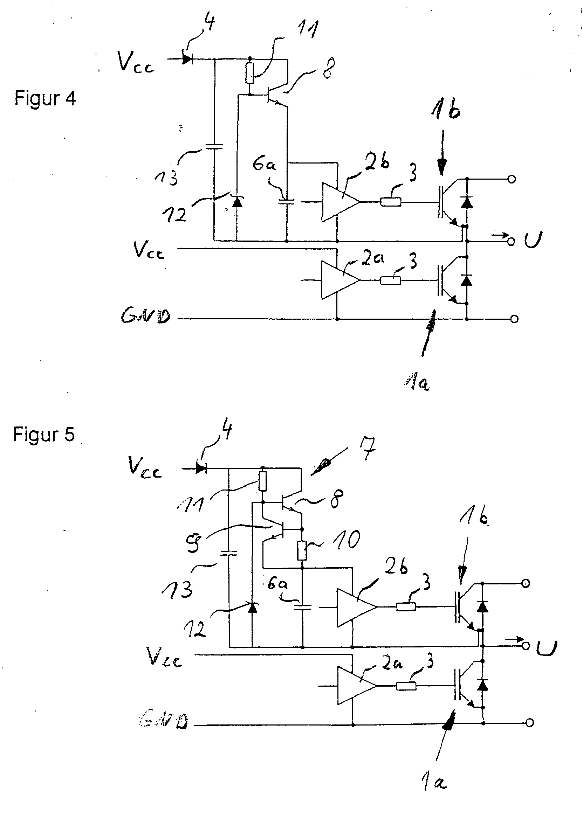

Die Ausführungsvariante gemäß Fig. 5 unterscheidet sich von der anhand von Fig. 3 vorbeschriebenen lediglich dadurch, dass parallel zur Zenerdiode 12 und dem Widerstand 11 ein weiterer Kondensator 13 geschaltet ist, der also mit seiner einen Seite an der Kathodenseite der Bootdiode 4 und mit seiner anderen Seite an U anliegt. Bei dieser Schaltungsanordnung sollte $V_{cc}$ mindestens zweimal so groß sein wie die zum Schalten des Transistors 1b erforderliche Steuerspannung. Dann kann in diesem Kondensator 13 auf hohem Spannungsniveau Energie gespeichert werden, wodurch der Bootkondensator 6a entlastet wird. Es kann in diesem Fall vollständig auf einen aufwändigen Tantalkondensator verzichtet werden, es genügt vielmehr ein üblicher Folienkondensator. Der Kondensator 13 hingegen kann ein kostengünstiger und kleinbauender Elektrolytkondensator vergleichsweise hoher Kapazität sein.

Bei der Ausführung gemäß Fig. 4 ist ebenfalls ein Kondensator 13 zwischen der Kathodenseite der Bootdiode 4 und U vorgesehen, um den Bootkondensator 6a geringer dimensionieren zu können, insbesondere um auf einen Tantalkondensator vollständig verzichten zu können. Bei der dort dargestellen Ausführungsvariante ist auf den Transistor 9 und den Widerstand 10 verzichtet worden, statt dessen liegt der Transistor 8 mit seinem Emitter direkt am Bootkondensator 6a an und mit seiner Basis an der Kathodenseite der Zenerdiode 12.

Bezugszeichenliste

1 - Transistoren

    a - Lowside
    b - Highside

2 - Gatetreiber

    a - Lowside
    b - Highside

3 - Widerstand
4 - Bootdiode
5 - Bootwiderstand
6 - Bootkondensator
6a - Bootkondensator in den Figuren 4 und 5
7 - Strombegrenzer
8 - Transistor
9 - Transistor
10 - Widerstand
11 - Widerstand
12 - Zenerdiode
13 - Kondensator (Fig. 5)

**Patentansprüche**

1. Bootstrap-Spannungsversorgung für den Treiber (2b) zum Ansteuern eines Halbleiterschaltelements (1b), insbesondere auf der Highside (b) eines Umrichters, wobei der Ausgang des Treibers (2b) mit dem Steuereingang des Schaltelements (1b) verbunden ist, **dadurch gekennzeichnet, dass** eine aktive Strombegrenzung (7) und eine Spannungsregelung (12) vorgesehen ist.

2. Bootstrap-Spannungsversorgung nach Anspruch 1, **dadurch gekennzeichnet, dass** die Steuerspannung des Treibers (2b) der an einem Bootkondensator (6) anliegenden Spannung entspricht und der Bootkondensator (6) einerseits über eine Bootdiode (4) und ggf. einen in Reihe dazu geschalteten Bootwiderstand (5) an einer im Wesentlichen konstanten Versorgungsspannung ($V_{cc}$) und andererseits an dem Umrichterausgang (U) des Schaltelements (1b) anliegt und dass der aktive Strombegrenzer (7) und/oder der Spannungsregler (12) zwischen Bootdiode (4) und Bootkondensator (6) geschaltet ist.

3. Bootstrap-Spannungsversorgung nach einem der vorhergehenden Ansprüche, **dadurch gekennzeichnet, dass** der Strombegrenzer (7) zwei zwischen Bootdiode (4) und Bootkondensator (6) mit ihrer Kollektor-Emitter-Strecke parallel geschaltete Transistoren (8, 9) aufweist, wobei die Basis des einen Transistors (8) mit dem Kollektor des anderen Transistors (9) und über einen Reihenwiderstand (11) mit der Bootdiode (4) und die Basis des anderen Transistors (9) mit dem Emitter des einen Transistors (8) und über einen Reihenwiderstand (10) mit dem Bootkondensator (6) verbunden ist.

4. Bootstrap-Spannungsversorgung nach einem der vorhergehenden Ansprüche, **dadurch gekennzeichnet, dass** die Versorgungsspannung mindestens 3 Volt über der Schaltspannung des Schaltelementes (1b) liegt.

5. Bootstrap-Spannungsversorgung nach einem der vorhergehenden Ansprüche, **dadurch gekennzeichnet, dass** der Spannungsregler durch eine zum Strombegrenzer (7) und dem Bootkondensator (6) parallel geschaltete Zenerdiode (12) gebildet ist.

6. Bootstrap-Spannungsversorgung nach einem der vorhergehenden Ansprüche, **dadurch gekennzeichnet, dass** ein weiterer Kondensator (13) parallel zum Spannungsregler (12) geschaltet ist und dass die Versorgungsspannung ($V_{cc}$) mindestens doppelt so hoch wie die Schaltspannung ist.

7. Bootstrap-Spannungsversorgung nach einem dervorhergehenden Ansprüche, **dadurch gekennzeichnet, dass** der Spannungsregler durch einen Transistor (8) gebildet ist, dessen Basis über eine Zenerdiode (12) mit dem Umrichterausgang (U) des Schaltelementes (1b) sowie mit einem Widerstand (11) verbunden ist, der mit der Bootdiode (4) sowie dem Kollektor des Transistors (8) verbunden ist, dass der Emitter des Transistors (8) mit der Seite des Treibers (2b) und des Bootkondensators (6a) verbunden ist, die nicht am Umrichterausgang (U) des Schaltelements (1b) anliegt, und dass ein weiterer Kondensator (13) zwischen dem Ausgang der Bootdiode (4) und dem Umrichterausgang (U) des Schaltelements (1b) vorgesehen ist.

Stand der Technik

Figur 1

Figur 2

Figur 3

Figur 4

Figur 5